# EUROPÄISCHE PATENTSCHRIFT

(11) **EP 1 143 256 B1**
(45) Veröffentlichungstag und Bekanntmachung des Hinweises auf die Patenterteilung: **26.01.2005**
(21) Anmeldenummer: 01104945.9
(22) Anmeldetag: 28.02.2001
(51) Int. Cl.: G01R 31/3185

(54) **Testanordnung zur Funktionsprüfung eines Halbleiterchips**
Test device for the functional testing of a semiconductor chip
Dispositif de test pour le test fonctionnel d'un circuit semiconducteur

(30) Priorität: 05.04.2000 DE 10016996
(43) Veröffentlichungstag der Anmeldung: 10.10.2001
(73) Patentinhaber: Infineon Technologies AG, 81669 München (DE)
(72) Erfinder: Kantz, Dieter, 81377 München (DE); Müller, Jochen, Dr., 81825 München (DE)
(74) Vertreter: Epping Hermann & Fischer

(56) Entgegenhaltungen:
- EP-A- 0 805 356
- WO-A-99/32893
- REUBER C: "LASERSTRAHL STATT PRUEFSPITZE" ELEKTRONIK, FRANZIS VERLAG GMBH. MUNCHEN, DE, Bd. 46, Nr. 24, 25. November 1997 (1997-11-25), Seite 96,98,100,102 XP000754379 ISSN: 0013-5658

## Beschreibung

Die vorliegende Erfindung betrifft eine Testanordnung zur Funktionsprüfung eines Halbleiterchips, der einem Funktionstest unterziehbar ist zum Überprüfen der Funktionsfähigkeit des Halbleiterchips.

Im Zuge der Herstellung von Halbleiterchips werden diese im allgemeinen wenigstens einem Funktionstest unterzogen, in dem die Funktionsfähigkeit eines Halbleiterchips überprüft wird. Dabei wird der Halbleiterchip beispielsweise mit einer externen Prüfeinrichtung geprüft, die Testinformation erzeugt und den Funktionstest durchführt. Die Testinformation wird dabei in den Halbleiterchip eingelesen und mit ausgelesenen Daten verglichen.

Eine Funktionsüberprüfung beispielsweise eines integrierten Halbleiterspeichers erfolgt üblicherweise in mehreren Schritten: in einer ersten Testanordnung werden Funktionstests an ungehäusten Halbleiterchips vorgenommen, die üblicherweise auf Halbleiterscheiben angeordnet sind (sogenannter Scheibentest oder Wafer-Level-Test). Diese Tests laufen im allgemeinen in komplexen Testsystemen parallel für mehrere Halbleiterchips ab, um Testzeit und Testkosten gering zu halten. In einer weiteren Testanordnung werden Funktionstests an dem gehäusten Halbleiterchip vorgenommen (sogenannter Bausteintest).

Bei Halbleiterspeichern steigen die Testzeit und der Testaufwand im allgemeinen mit zunehmender Speicherdichte deutlich an und steigern damit die Testkosten und auch die Herstellkosten. Bei Verwendung eines externen Testgerätes für einen Scheibentest werden im allgemeinen über eine begrenzte Anzahl von Ansteuerkanälen mittels der sogenannten Nadelkartentechnik (sogenannte Probecards) Testsignale, Steuersignale und Betriebsspannung bzw. Betriebsstrom zugeführt. Die Anzahl parallel zu testender Speicherchips ist dabei aufgrund mechanisch bedingter Probleme bei der Nadelkartentechnik beispielsweise zur Zuführung der Betriebsspannung begrenzt.

EP605356 offenbart ein Chip mit aufgebrachten Hall-Elementen zur kontaktlosen Übertragung von Messdaten oder zur Erzeugung eines Messstroms für einen Kontinuitätstest.

WO9932893 offenbart ein Chip mit einer Testeinheit, die einen elektromagnetischen Empfänger und Sender aufweist, damit die Testinformation in den Halbleiterchip kontaktlos eingelesen oder vom Chip ausgelesen wird.

Die Aufgabe der vorliegenden Erfindung ist es, eine Testanordnung zur Funktionsprüfung eines Halbleiterchips anzugeben, die es ermöglicht, die Testzeit und die Testkosten für einen durchzuführenden Funktionstest vergleichsweise gering zu halten.

Die Aufgabe wird gelöst durch eine Testanordnung zur Funktionsprüfung eines Halbleiterchips mit einem Halbleiterchip, der einem Funktionstest unterziehbar ist zum Überprüfen der Funktionsfähigkeit des Halbleiterchips, der auf einem Trägermaterial angeordnet ist, und der eine Selbsttesteinheit aufweist zur Erzeugung von Testinformation und zur Durchführung des Funktionstests, mit einer Energiequelle zur Bereitstellung einer elektrischen Energieversorgung aus kontaktlos zugeführter Energie, bei der die Energiequelle auf dem Trägermaterial angeordnet ist und mit dem Halbleiterchip verbunden ist zur Bereitstellung einer Energieversorgung für den Halbleiterchip.

Durch die erfindungsgemäße Testanordnung ist es möglich, eine im Prinzip beliebig hohe Anzahl von zu testenden Halbleiterchips parallel auf Funktionsfähigkeit zu testen. Durch die Selbsttesteinheit ist es möglich, unabhängig von einem externen Testgerät Testinformation zu erzeugen und einen Funktionstest durchzuführen. Es ist also nicht notwendig, einen zu testenden Halbleiterchip über externe Anschlüsse für Testoder Steuersignale mit einer externen Testeinrichtung zu kontaktieren. Da außerdem eine Energiequelle zur Bereitstellung einer elektrischen Energieversorgung aus kontaktlos zugeführter Energie auf dem Trägermaterial, beispielsweise einer Halbleiterscheibe, angeordnet ist und mit dem Halbleiterchip verbunden ist, können außerdem externe Anschlüsse zur Zuführung einer Betriebsspannung und/oder eines Betriebsstromes entfallen. Die Anzahl parallel zu testender Halbleiterchips ist dadurch nicht mehr aufgrund mechanisch bedingter Probleme beispielsweise bei der Nadelkartentechnik begrenzt. Die Testkosten bzw. Herstellkosten werden zusätzlich gesenkt, da kein externes Testgerät benötigt wird.

Sind mehrere Halbleiterchips beispielsweise auf einer Halbleiterscheibe angeordnet, so ist es möglich, neben den Halbleiterchips der Halbleiterscheibe auch mehrere Halbleiterscheiben bzw. deren aufgebrachte Halbleiterchips einem parallelen Funktionstest zu unterziehen. Dieser kann durch die erfindungsgemäße Testanordnung als kontaktloser Scheibentest durchgeführt werden.

In einer Weiterbildung der Erfindung weist die Energiequelle wenigstens eine Solarzelle auf zur Erzeugung eines Betriebsstroms auf einem zu testenden Halbleiterchip durch kontaktlos zugeführte optische Strahlung. Die Solarzelle wird dazu beispielsweise mit sichtbarem Licht bestrahlt, so daß ein Stromfluß erzeugt wird, der als Betriebsstrom auf dem Halbleiterchip dient.

Bei einer Testanordnung, bei der mehrere zu testende Halbleiterchips auf einer Halbleiterscheibe aufgebracht sind, ist die Solarzelle in einer Ausführungsform in dem Ritzrahmen der Halbleiterscheibe angeordnet. Dieser trennt die Halbleiterchips auf der Halbleiterscheibe voneinander. Entlang dieses Ritzrahmens werden in einem späteren Herstellungsprozeß die Halbleiterchips voneinander getrennt, indem die Halbleiterscheibe entlang des Ritzrahmens auseinander gesägt wird (sogenanntes Dicing). Der dazu benötigte Platzbedarf auf der Halbleiterscheibe kann in vorteilhafter Weise genutzt werden, indem die Solarzelle in dem Ritzrahmen angeordnet ist. Da die Solarzelle für eine späteren Betrieb des Halbleiterchips nicht mehr benötigt wird, ist es nicht erheblich, daß diese beim späteren Durchsägen der Halbleiterscheibe zerstört wird.

Um eine ausreichende Stromerzeugung durch die Solarzelle zu erreichen, ist eine relativ große Fläche für die Solarzelle notwendig. Durch eine dadurch notwendige Vergrößerung des Ritzrahmens kann die Anzahl der Halbleiterchips auf der Halbleiterscheibe im allgemeinen reduziert werden. Dieser Nachteil muß gegen die Einsparung der Testkosten abgewägt werden.

In einer weiteren Ausführungsform der Erfindung ist die Solarzelle flächig auf einer Oberfläche der Halbleiterscheibe, auf der der zu testende Halbleiterchip aufgebracht ist, angeordnet. Bei 100%iger Photonenausbeute der Solarzelle kann diese direkt auf die Halbleiterscheibe bzw. den Halbleiterchip aufgebracht werden. Ist die Solarzelle jedoch lichtdurchlässig, so ist es zweckmäßig, daß zwischen Solarzelle und dem Halbleiterchip eine strahlungsabsorbierende Schicht aufgebracht wird, um eine Ladungsträgererzeugung auf dem Chip zu vermeiden.

In einer weiteren Ausführungsform der Erfindung ist die Solarzelle auf der Oberfläche des Trägermaterials angeordnet, die dem zu testenden Halbleiterchip abgewandt ist. Ist die Solarzelle also auf der Rückseite des Trägermaterials, beispielsweise einer Halbleiterscheibe, angeordnet, so ist eine Durchkontaktierung von der Solarzelle durch das Substrat der Halbleiterscheibe auf die andere Seite der Halbleiterscheibe erforderlich. An der Begrenzung der Durchkontaktierung zum Trägermaterial bzw. zur Halbleiterscheibe ist eine Strombarriere in Form eines pn-Übergangs längs der Durchkontaktierung angeordnet um einen Stromfluß zwischen der Durchkontaktierung und der Halbleiterscheibe zu vermeiden. Um die Durchkontaktierung einfach zu gestalten, muß die Halbleiterscheibe eventuell auf das erforderliche Maß gedünnt werden. Im Falle einer teiltransparenten Solarzelle ist es auch hier erforderlich, zur Verhinderung einer Ladungsträgererzeugung zwischen der Solarzelle und dem Halbleiterchip eine strahlungsabsorbierende Schicht anzuordnen.

Bei der Verwendung einer Solarzelle zur Erzeugung einer Energieversorgung auf einem zu testenden Halbleiterchip muß generell bei gegebener Fläche hinreichend viel Betriebsstrom erzeugt werden, um den Halbleiterchip während des Funktionstests zu betreiben. Im allgemeinen werden zur Durchführung von Scheibentests keine Funktionstests durchgeführt, die empfindlich hinsichtlich einer Betriebsfrequenz sind. Dies bedeutet, daß hier im allgemeinen bei niedrigen Betriebsfrequenzen getestet werden kann. Dadurch wird der Betriebsstrom vergleichsweise niedrig gehalten. Die Anforderungen an die Stromtreibefähigkeit der Solarzelle sind somit entspannt. Bei einem Test beispielsweise eines Speicherchips ist die Gesamttestzeit hauptsächlich durch die sogenannten Retention Tests für die Speicherzellen gegeben, zu einem kleineren Anteil durch die Betriebsfrequenz selbst. Da zudem alle Chips auf einer Halbleiterscheibe parallel getestet werden können, fällt eine niedrige Betriebsfrequenz während eines Funktionstests kaum ins Gewicht.

Halbleiterchips können im Falle eines Kurzschlusses relativ viel Strom benötigen. Um eine Störung eines Funktionstests zu vermeiden, werden defekte Chips, die auf einer Halbleiterscheibe angeordnet sind, bevorzugt während des parallelen Tests von anderen funktionsfähigen Chips der Halbleiterscheibe bezüglich der Energieversorgung entkoppelt. Dies kann dadurch erfolgen, daß pro Halbleiterchip eine separate Solarzelle verwendet wird, die auf dem Halbleiterchip angeordnet ist.

Bei Verwendung einer gemeinsamen Energiequelle zur gemeinsamen Stromversorgung mehrerer zu testender Halbleiterchips weisen die zu testenden Chips vorteilhafterweise jeweils eine Strombegrenzerschaltung auf zur Trennung eines jeweiligen Halbleiterchips von der Energiequelle im Falle einer Überschreitung eines Grenzwertes eines Betriebsstromes. Falls der Stromverbrauch eines zu testenden Chips, beispielsweise im Kurzschlußfall, über dem Grenzwert liegt, wird der zu testende Chip nicht weiter getestet und von der Energieversorgung durch die Strombegrenzerschaltung getrennt.

Im Interesse möglichst geringer Herstellkosten ist es zweckmäßig, daß die Prozeßschritte zur Erzeugung bzw. zur Abscheidung der Solarzelle in die Prozeßschritte zur Herstellung eines Halbleiterchips integrierbar sind. Dies gilt insbesondere hinsichtlich der zu verwendenden Materialien und Prozeßtemperaturen.

Um eine benötigte Fläche für eine Solarzelle möglichst gering zu halten, sollte die Strahlungsquelle bzw. Lichtquelle eine möglichst hohe Energiedichte aufweisen. Außerdem sollte diese an die Leistungscharakteristika der Solarzelle angepaßt sein. Die Strahlungsquelle kann beispielsweise durch eine UV-Lichtquelle oder durch einen ausgeweiteten Laserstrahl realisiert werden.

Soll Information über die Durchführung eines Funktionstests und/oder ein Testergebnis ausgewertet werden, so ist es erforderlich, diese ebenfalls kontaktlos beispielsweise an eine externe Auswerteeinrichtung zu übertragen. Eine Testinformation kann dabei im einfachsten Fall eine sogenannte Passoder Fail-Information sein, die aussagt, ob ein getesteter Halbleiterchip ordnungsgemäß funktioniert. Auszuwertende Daten können außerdem Information über die Einteilung in eine Geschwindigkeitsklasse oder ähnliche Unterscheidungskriterien enthalten.

Kann ein zu testender Halbleiterchip durch eine vorhandene Redundanz auf dem Halbleiterchip beispielsweise durch die Selbsttesteinheit repariert werden, so ist es vorteilhaft, detailliertere Informationen über eine Reparatur zu erhalten, um Aussagen über die Fehlerdichte auf dem Chip machen zu können. So können beispielsweise bei einem zu testenden Speicherchip die Adressen vom fehlerhaften Speicherzellen ermittelt werden und ausgewertet werden, wieviel der vorhandenen Redundanz zur Reparatur eingesetzt wurde.

Zum Transfer und zur Auswertung von Testinformation über die Testdurchführung und/oder ein Testergebnis weist der Halbleiterchip in einer Ausführungsform der Erfindung eine Funktionseinheit auf zur kontaktlosen Übertragung von Daten, die die auszulesende Testinformation enthalten.

Die Funktionseinheit ist dazu beispielsweise zur Erzeugung von optischen Strahlungsimpulsen entsprechend der zu übertragenden Daten ausgebildet. Die Strahlungsimpulse sind von einem Empfänger außerhalb des Halbleiterchips empfangbar. Dazu wird beispielsweise ein Halbleiterlaser auf dem Halbleiterchip vorgesehen, der entsprechende Strahlungsimpulse erzeugt. Dabei ist auf eine ausreichende Streulichtabschirmung und Kalibrierung des Empfängers bei einer Verwendung einer Solarzelle zu achten, um das auszulesende Signal unter der Beleuchtung zur Stromerzeugung sicher detektieren zu können. Der Halbleiterlaser wird beispielsweise an die Stelle eines Anschlußpads des Chips vorgesehen. Dieses Pad muß zur Emittierung der Strahlung freigelassen werden. Die zu emittierenden Strahlungsimpulse können beispielsweise durch Laserlicht, das schräg zur Oberfläche der Halbleiterscheibe abstrahlt, erzeugt werden.

In einer anderen Ausführungsform der Erfindung weist die Funktionseinheit einen Ausgangsanschluß auf, über den die zu übertragenden Daten durch kapazitive Kopplung an einen Empfänger außerhalb des Halbleiterchips übertragbar sind. Dazu wird dem Ausgangsanschluß, beispielsweise in Form eines Ausgangspads, eine Prüfspitze in vergleichsweise geringem Abstand gegenübergestellt und die zu übertragende Information durch kapazitive Kopplung transferiert. Bei einer Anordnung der Solarzelle auf der Oberfläche einer Halbleiterscheibe, die den zu testenden Halbleiterchips zugewandt ist, muß die Anordnung der Prüfspitzen eine hinreichende Beleuchtung der Scheibenoberfläche erlauben.

In einer anderen Ausführungsform der Erfindung ist ein Material, beispielsweise ein Halbleitermaterial, mit einem Anschluß der Funktionseinheit verbunden, an dem ein durch die Funktionseinheit steuerbares Potential entsprechend der zu übertragenden Daten anliegt. Das Material bewirkt dabei eine durch das Potential steuerbare optische Brechung von eingestrahlter optischer Strahlung. Das Material wird dazu mit optischer Strahlung bestrahlt, die durch das Material gebrochene optische Strahlung wird von einem Empfänger außerhalb des Halbleiterchips empfangen. Es werden also mittels einer elektrooptischen Steuerung durch Ausnutzung von elektrischen Streufeldern an dem Anschluß der Funktionseinheit Änderungen der Brechzahl eines entsprechenden Materials bewirkt. Die Brechzahl ändert sich dabei in Folge des anliegenden Potentials, das durch die Funktionseinheit gesteuert wird. Die sich dadurch ergebenden unterschiedlichen Brechungswinkel werden durch den Empfänger ausgewertet.

Um einen Transfer der auszulesenden Testinformationen zu starten, weist der Halbleiterchip in einer vorteilhaften Ausführungsform einen Spannungsdetektor oder einen Stromdetektor auf, der mit der Energiequelle und der Funktionseinheit verbunden ist. Bei Auftreten einer charakteristischen Spannungsabfolge bzw. Stromabfolge wird eine Datenübertragung durch die Funktionseinheit ausgelöst. Die dazu erforderliche Spannungs- bzw. Stromstärkeabfolge wird durch eine entsprechende Variation der Strahlungsintensität erzeugt.

In einer weiteren Ausführungsform ist der Spannungsdetektor bzw. der Stromdetektor mit der Energiequelle und der Selbsttesteinheit verbunden, wobei durch eine detektierte charakteristische Spannungsabfolge bzw. Stromabfolge der Beginn eines Funktionstests durch die Selbsttesteinheit ausgelöst wird.

Ein Transfer von Informationen von beispielsweise einer externen Prüfeinrichtung in einen zu prüfenden Halbleiterchip zu Beginn eines Testablaufes ist nicht notwendig. Diese Information kann beispielsweise in einem ROM (Read Only Memory) hinterlegt werden. Die Information wird für einen Funktionstest von der Selbsttesteinheit eingelesen.

In einer weiteren Ausführungsform der Erfindung weist der Halbleiterchip eine nicht flüchtige Speichereinheit auf zur Speicherung von Daten, die Information über die Testdurchführung und/oder ein Testergebnis enthalten. Zum Auslesen dieser Daten ist die nicht flüchtige Speichereinheit mit einem Anschluß des Halbleiterchips verbunden, über den die Daten der Speichereinheit nach außerhalb des Halbleiterchips abgreifbar sind. Diese Ausführungsform ist insbesondere vorteilhaft bei Funktionstests, bei denen Testinformationen in einem begrenzten Umfang ausgelesen werden. Diese Information kann beispielsweise in elektrisch programmierbaren Fuses nicht flüchtig gespeichert werden. In einem nächsten Testschritt, beispielsweise bei einem Bausteintest, der nach einem Scheibentest durchgeführt wird, kann diese Information ausgelesen werden.

In einer Weiterbildung des Halbleiterchips weist dieser einen integrierten Speicher auf, der Speicherzellen enthält, die einem Funktionstest unterziehbar sind. Die Selbsttesteinheit ist dazu zur Erzeugung von Testinformation und zur Durchführung eines Funktionstests der Speicherzellen ausgebildet. Diese erzeugt die für einen Funktionstest notwendigen sogenannten Test-Patterns und Timings.

Weist der integrierte Speicher in einer Ausführungsform neben normalen Speicherzellen auch redundante Speicherzellen zum Ersetzen von normalen Speicherzellen auf, so kann eine Reparatur von defekten normalen Speicherzellen vorgenommen werden. Durch die Selbsttesteinheit wird die Funktionsfähigkeit der normalen Speicherzellen überprüft, anschließend wird eine Analyse vorgenommen, welche der normalen Speicherzellen durch welche der redundanten Speicherzellen zu ersetzen sind. Durch Berechnung aus dem ermittelten Fehlerbild des Speichers wird also die Reparaturinformation erzeugt. Ein entsprechender Redundanzalgorithmus ist dazu in geeigneter Weise in der Selbsttesteinheit hinterlegt (beispielsweise in einem ROM). Nach Ermittlung der Reparaturinformation werden die redundanten Speicherzellen entsprechend dem Analyseergebnis durch die Selbsttesteinheit aktiviert. Diese Aktivierung kann in einer weiteren Ausführungsform auch durch elektrisch programmierbare Speichereinheiten vorgenommen werden, in denen ein durch die Selbsttesteinheit ermitteltes Reparaturergebnis programmierbar ist. Die beschriebene Reparatur eines Speicherchips ist insbesondere bei sogenannten DRAMs und eDRAMs anwendbar.

Weitere vorteilhafte Aus- und Weiterbildungen sind Gegenstand abhängiger Ansprüche.

Die Erfindung wird im folgenden anhand der in der Zeichnung dargestellten Figuren, die jeweils Ausführungsbeispiele darstellen, näher erläutert. Es zeigen:
- Figur 1: eine Ausführungsform einer erfindungsgemäßen Testanordnung,
- Figuren 2 und 3: weitere detaillierte Ausführungsformen der Testanordnung,
- Figuren 4 und 5: Ausführungsformen der Erfindung bezüglich der Anordnung einer Solarzelle.

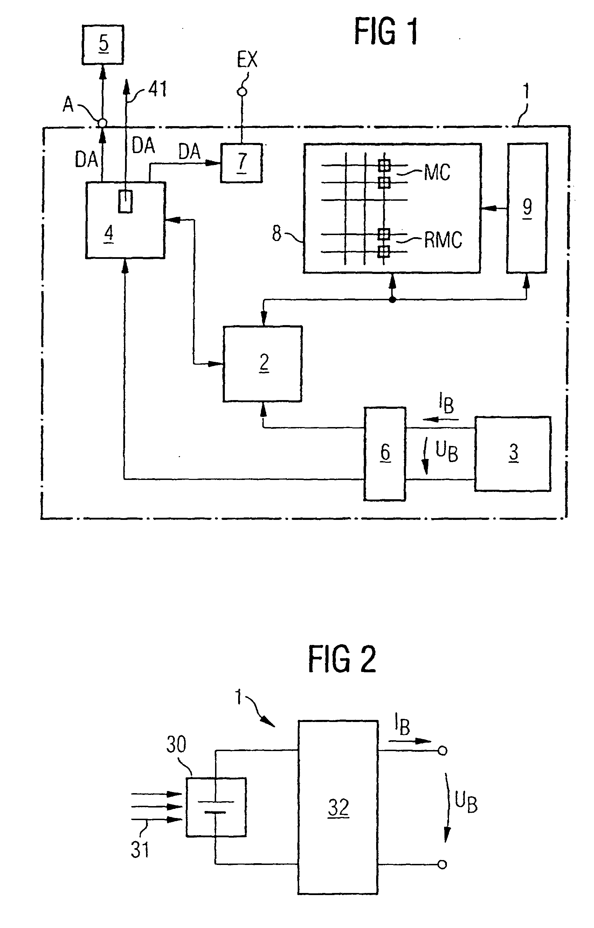

Figur 1 zeigt einen Halbleiterchip 1, der hier als integrierter Speicher ausgeführt ist. Der Speicher weist ein matrixförmiges Speicherzellenfeld 8 auf mit normalen Speicherzellen MC und redundanten Speicherzellen RMC zum Ersetzen von fehlerhaften normalen Speicherzellen MC, die jeweils entlang von Spaltenleitungen und Zeilenleitungen angeordnet sind. Der Halbleiterchip 1 weist außerdem eine Selbsttesteinheit 2 auf, auch als BIST (Built-In-Self-Test) bezeichnet, zur Erzeugung von Testinformation und zur Durchführung eines Funktionstests der normalen Speicherzellen MC. Dazu werden beispielsweise Prüfmuster (sogenannte Patterns) in das Speicherzellenfeld 8 eingelesen und mit ausgelesenen Daten verglichen. Die Selbsttesteinheit 2 überprüft dabei die Funktionsfähigkeit der normalen Speicherzellen MC. Durch die Selbsttesteinheit 2 werden außerdem die Spannungsniveaus der Ansteuersignale erzeugt. Die Selbsttesteinheit 2 führt anschließend eine Analyse durch, welche der normalen Speicherzellen MC durch welche der redundanten Speicherzellen RMC zu ersetzen sind. Es erfolgt dann eine Abspeicherung der Reparaturinformation.

Der Speicherchip 1 weist dazu elektrisch programmierbare Speichereinheiten 9 auf, in denen ein durch die Selbsttesteinheit 2 ermitteltes Reparaturergebnis programmiert werden kann. Die elektrisch programmierbaren Speichereinheiten 9 sind beispielsweise als sogenannte elektrische Fuses ausgeführt, die ebenfalls durch die Selbsttesteinheit 2 programmierbar sind. In den Speichereinheiten 9 sind beispielsweise Adressen von fehlerhaften normalen Speicherzellen MC gespeichert. Zum Ersatz von fehlerhaften normalen Speicherzellen MC werden entsprechende redundante Speicherzellen RMC durch die Speichereinheiten 9 aktiviert.

Zur Bereitstellung einer elektrischen Energieversorgung auf dem Halbleiterchip 1 ist eine Energiequelle 3 vorgesehen, die eine elektrische Energieversorgung aus kontaktlos zugeführter Energie bereitstellt. Die Energiequelle 3 ist in diesem Ausführungsbeispiel auf dem Halbleiterchip 1 angeordnet. Die Energiequelle 3 ist mit einem Spannungsdetektor oder Stromdetektor 6 verbunden, der eine charakteristische Spannungsabfolge bzw. Stromabfolge der Betriebsspannung UB bzw. des Betriebsstroms IB detektieren kann. Der Spannungsdetektor bzw. Stromdetektor 6 ist mit der Selbsttesteinheit 2 verbunden zum Auslösen eines Funktionstests in Folge einer detektierten charakteristischen Spannungsabfolge bzw. Stromabfolge.

Der Halbleiterchip 1 weist weiterhin eine Funktionseinheit 4 auf, die zur kontaktlosen Übertragung von Daten DA ausgebildet ist, die Information über die Testdurchführung und/oder ein Testergebnis enthalten. Die Funktionseinheit 4 enthält beispielsweise einen Halbleiterlaser, durch welchen optische Strahlungsimpulse 41 erzeugt werden können entsprechend der zu übertragenden Daten DA. Die optischen Strahlungsimpulse 41 werden von einem Empfänger 5 außerhalb des Halbleiterchips 1 empfangen. Die Funktionseinheit 4 ist mit der Selbsttesteinheit 2 verbunden. Die Funktionseinheit 4 ist weiterhin mit dem Spannungsdetektor oder Stromdetektor 6 verbunden, der bei Detektion einer charakteristischen Spannungsabfolge bzw. Stromabfolge eine Datenübertragung durch die Funktionseinheit 4 auslöst.

In einer anderen Ausführungsform weist die Funktionseinheit 4 einen Ausgangsanschluß A auf, beispielsweise in Form eines Anschlußpads, über den die zu übertragenden Daten DA durch kapazitive Kopplung an den Empfänger 5 übertragen werden. Der Empfänger 5 weist dazu geeignete Prüfspitzen auf, die in einem genügend kleinen Abstand zum Anschluß A angeordnet werden.

Der Halbleiterchip 1 enthält weiterhin eine nicht flüchtige Speichereinheit 7 zur Speicherung der Daten DA. Die Speichereinheit 7 ist mit einem Anschluß EX des Halbleiterchips verbunden. An dem Anschluß EX werden beispielsweise während eines Bausteintests die gespeicherten Daten DA der Speichereinheit 7 ausgelesen.

In Figur 2 ist eine Ausführungsform der Testanordnung als elektrisches Prinzipschaltbild dargestellt. Die Energiequelle 3 weist dabei eine Solarzelle 30 auf, durch die ein Betriebsstrom IB auf dem Halbleiterchip 1 durch kontaktlos zugeführte optische Strahlung 31 erzeugt werden kann. In dem Strompfad der Solarzelle 30 ist eine Strombegrenzerschaltung 32 vorgesehen, die im Falle einer Überschreitung eines Grenzwertes des Betriebsstroms IB den Halbleiterchip 1 von der Solarzelle 30 trennt. Dies ist insbesondere dann von Vorteil, wenn die Solarzelle 30 als gemeinsame Energiequelle für mehrere zu testende Halbleiterchips verwendet wird. So werden beispielsweise im Kurzschlußfall andere zu testende Halbleiterchips nicht beeinflußt, da der fehlerhafte Chip durch die Strombegrenzerschaltung 32 von der Energieversorgung getrennt wird.

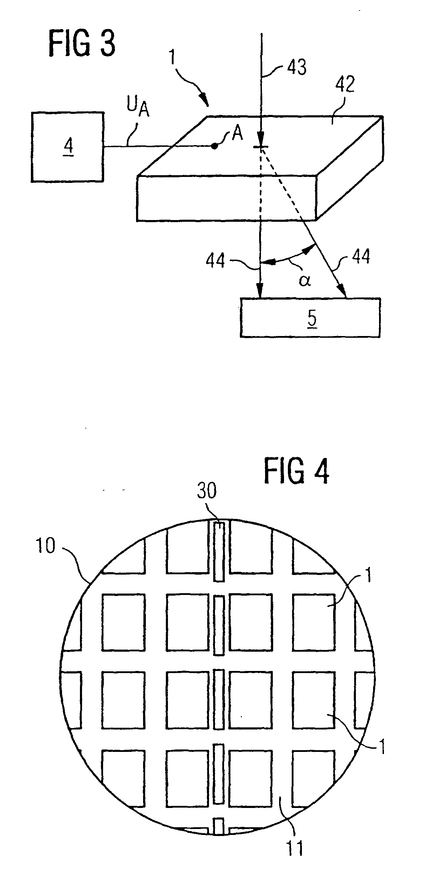

In Figur 3 ist eine weitere Ausführungsform der Testanordnung dargestellt. Der Halbleiterchip 1 weist ein Material 42 auf, das mit optischer Strahlung 43 bestrahlt wird. Dabei ist die optische Brechung der optischen Strahlung 43 durch ein Potential UA steuerbar. Als Folge davon ergeben sich unterschiedliche Brechungswinkel α der gebrochenen optischen Strahlung 44. Die gebrochene Strahlung 44 wird von dem Empfänger 5 außerhalb des Halbleiterchips 1 empfangen. Das Material 42 ist mit dem Anschluß A der Funktionseinheit 4 verbunden, an dem das Potential UA anliegt. Dieses Potential ist entsprechend der zu übertragenden Daten DA steuerbar. Das bedeutet, der Brechnungswinkel α wird in Abhängigkeit der zu übertragenden Daten DA variiert. So werden elektrische Streufelder an dem Anschluß A durch das dort anliegende Potential UA mittels einer elektrooptischen Steuerung ausgenutzt.

Figur 4 zeigt eine Ausführungsform einer Anordnung von mehreren Halbleiterchips 1, die auf einem Träger 10 angeordnet sind. Der Träger 10 ist in Figur 4 als Halbleiterscheibe, beispielsweise in Form eines Wafers, ausgebildet. Die Halbleiterscheibe 10 weist einen Ritzrahmen 11 auf, in dem die Solarzellen 30 angeordnet sind. Die Halbleiterchips 1 werden entlang des Ritzrahmens 11 zu einem späteren Zeitpunkt der Herstellung ausgesägt.

Figur 5a zeigt in einer weiteren Ausführungsform einen Querschnitt einer Anordnung, bei der auf einem Substrat bzw. einer Halbleiterscheibe 10 mehrere Halbleiterchips 1 angeordnet sind. Die Solarzelle 30 ist dabei ganzflächig auf der Oberfläche der Halbleiterscheibe 10 angeordnet. Zwischen der Solarzelle 30 und der Halbleiterscheibe 10 ist eine strahlungsabsorbierende Schicht 12 aufgebracht. Im Falle, daß die Solarzelle 30 Strahlung nach unten zur Halbleiterscheibe 10 durchläßt, wird durch die strahlungsabsorbierende Schicht 12 eine Ladungsträgererzeugung auf den Halbleiterchips 1 vermieden.

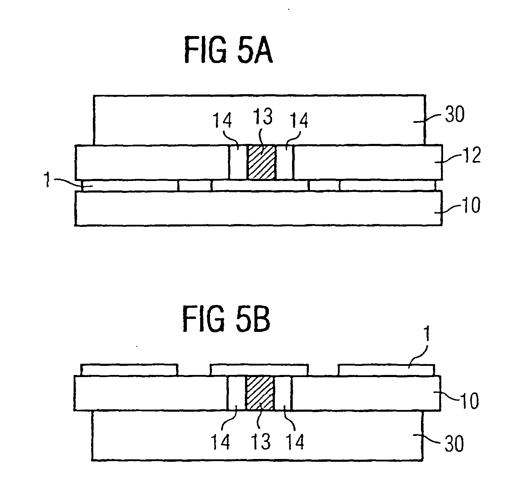

Figur 5b zeigt in einer weiteren Ausführungsform eine Anordnung, bei der die Solarzelle 30 auf der unteren Oberfläche eines Substrats bzw. der Halbleiterscheibe 10 angeordnet ist, die den Halbleiterchips 1 abgewandt ist. Zwischen der Solarzelle 30 und dem jeweiligen Halbleiterchip 1 ist eine elektrisch leitende Durchkontaktierung 13 in dem Substrat angeordnet, beispielhaft an einer einzigen Durchkontaktierung 13 gezeigt. An der Begrenzung der Durchkontaktierung 13 zum Substrat ist ein pn-Übergang 14 längs der Durchkontaktierung 13 angeordnet. Der pn-Übergang 14 dient dabei zur Verhinderung eines Stromflusses zwischen der Durchkontaktierung 13 und dem Substrat. Die Durchkontaktierung 13 und der pn-Übergang 14 sind in ähnlicher Weise zum gleichen Zweck in der strahlungsabsorbierenden Schicht 12 gemäß Figur 5a angeordnet. Diese kann auch in der Anordnung nach Figur 5b zusätzlich vorgesehen werden.

## Patentansprüche

1. Testanordnung zur Funktionsprüfung eines Halbleiterchips
- mit einem Halbleiterchip (1), der einem Funktionstest unterziehbar ist zum Überprüfen der Funktionsfähigkeit des Halbleiterchips (1), der auf einem Trägermaterial (10) angeordnet ist, und der eine Selbsttesteinheit (2) aufweist zur Erzeugung von Testinformation und zur Durchführung des Funktionstests,
- mit einer Energiequelle (3) zur Bereitstellung einer elektrischen Energieversorgung aus kontaktlos zugeführter Energie,
- bei der die Energiequelle (3) auf dem Trägermaterial (10) angeordnet ist und mit dem Halbleiterchip (1) verbunden ist zur Bereitstellung einer Energieversorgung für den Halbleiterchip (1).

2. Testanordnung nach Anspruch 1,
**dadurch gekennzeichnet, daß**
die Energiequelle (3) wenigstens eine Solarzelle (30) aufweist zur Erzeugung eines Betriebsstromes (IB) auf dem Halbleiterchip (1) durch kontaktlos zugeführte optische Strahlung (31).

3. Testanordnung nach Anspruch 2,
**dadurch gekennzeichnet, daß**
- das Trägermaterial eine Halbleiterscheibe (10) ist, auf der mehrere Halbleiterchips (1) aufgebracht sind,
- die Halbleiterscheibe (10) einen Ritzrahmen (11) aufweist, der die Halbleiterchips (1) voneinander trennt, und
- die Solarzelle (30) in dem Ritzrahmen (11) angeordnet ist.

4. Testanordnung nach Anspruch 2,
**dadurch gekennzeichnet, daß**
die Solarzelle (30) auf dem Halbleiterchip (1) angeordnet ist.

5. Testanordnung nach Anspruch 2,
**dadurch gekennzeichnet, daß**
- das Trägermaterial eine Halbleiterscheibe (10) ist, auf der der Halbleiterchip (1) aufgebracht ist, und
- die Solarzelle (30) flächig auf einer Oberfläche der Halbleiterscheibe (10) angeordnet ist.

6. Testanordnung nach Anspruch 2 oder 5,
**dadurch gekennzeichnet, daß**
- die Solarzelle (30) auf der Oberfläche des Trägermaterials (10) angeordnet ist, die dem Halbleiterchip (1) abgewandt ist,
- zwischen der Solarzelle (30) und dem Halbleiterchip (1) eine elektrisch leitende Durchkontaktierung (13) in dem Trägermaterial (10) angeordnet ist,
- an der Begrenzung der Durchkontaktierung (13) zum Trägermaterial (10) ein pn-Übergang (14) längs der Durchkontaktierung (13) angeordnet ist zur Verhinderung eines Stromflusses zwischen der Durchkontaktierung (13) und dem Trägermaterial (10).

7. Testanordnung nach einem der Ansprüche 4 bis 6 ,
**dadurch gekennzeichnet, daß**
zwischen der Solarzelle (30) und dem Halbleiterchip (1) eine strahlungsabsorbierende Schicht (12) aufgebracht ist.

8. Testanordnung nach einem der Ansprüche 1 bis 7,
**dadurch gekennzeichnet, daß**
der Halbleiterchip (1) eine Funktionseinheit (4) aufweist zur kontaktlosen Übertragung von Daten (DA), die Information über die Testdurchführung und/oder ein Testergebnis enthalten.

9. Testanordnung nach Anspruch 8,
**dadurch gekennzeichnet, daß**
die Funktionseinheit (4) zur Erzeugung von optischen Strahlungsimpulsen (41) entsprechend den zu übertragenen Daten (DA) ausgebildet ist, die von einem Empfänger (5) außerhalb des Halbleiterchips (1) empfangbar sind.

10. Testanordnung nach Anspruch 8,
**dadurch gekennzeichnet, daß**
die Funktionseinheit (4) einen Ausgangsanschluß (A) aufweist, über den die zu übertragenen Daten (DA) durch kapazitive Kopplung an einen Empfänger (5) außerhalb des Halbleiterchips (1) übertragbar sind.

11. Testanordnung nach Anspruch 8,
**dadurch gekennzeichnet, daß**
- ein Material (42) mit einem Anschluß (A) der Funktionseinheit (4) verbunden ist, an dem ein durch die Funktionseinheit (4) steuerbares Potential (UA) entsprechend den zu übertragenen Daten (DA) anliegt,
- das Material (42) eine durch das Potential (UA) steuerbare optische Brechung (α) von optischer Strahlung (43) bewirkt,
- das Material (42) mit optischer Strahlung (43) bestrahlbar ist und durch das Material (42) gebrochene optische Strahlung (44) von einem Empfänger (5) außerhalb des Halbleiterchips (1) empfangbar ist.

12. Testanordnung nach einem der Ansprüche 8 bis 11,
**dadurch gekennzeichnet, daß**
der Halbleiterchip (1) einen Spannungsdetektor (6) oder einen Stromdetektor (6) aufweist, der mit der Energiequelle (3) und der Funktionseinheit (4) verbunden ist zum Auslösen einer Datenübertragung durch die Funktionseinheit (4) infolge einer detektierten charakteristischen Spannungsabfolge bzw. Stromabfolge.

13. Testanordnung nach einem der Ansprüche 1 bis 12,
**dadurch gekennzeichnet, daß**
- der Halbleiterchip (1) eine nicht flüchtige Speichereinheit (7) aufweist zur Speicherung von Daten (DA), die Information über die Testdurchführung und/oder ein Testergebnis enthalten, und
- die nicht flüchtige Speichereinheit (7) mit einem Anschluß (EX) des Halbleiterchips (1) verbunden ist, über den die Daten (DA) der Speichereinheit (7) nach außerhalb des Halbleiterchips (1) abgreifbar sind.

14. Testanordnung nach einem der Ansprüche 1 bis 13,
**dadurch gekennzeichnet, daß**
- die Testanordnung mehrere zu testende Halbleiterchips (1) aufweist und
- einer der zu testenden Halbleiterchips (1) während eines Funktionstests bezüglich der Energieversorgung von den jeweiligen anderen Halbleiterchips (1) entkoppelt ist.

15. Testanordnung nach einem der Ansprüche 1 bis 13,
**dadurch gekennzeichnet, daß**
- die Testanordnung mehrere zu testende Halbleiterchips (1) aufweist,
- die Testanordnung für mehrere der zu testenden Halbleiterchips (1) eine gemeinsame Energiequelle (3) aufweist,
- die zu testenden Halbleiterchips (1) jeweils eine Strombegrenzerschaltung (32) aufweisen zur elektrischen Trennung eines jeweiligen Halbleiterchips (1) von der Energiequelle (3) im Falle einer Überschreitung eines Grenzwertes eines Betriebsstromes (IB).

16. Testanordnung nach einem der Ansprüche 1 bis 15,
**dadurch gekennzeichnet, daß**
der Halbleiterchip (1) einen Spannungsdetektor (6) oder einen Stromdetektor (6) aufweist, der mit der Energiequelle (3) und der Selbsttesteinheit (2) verbunden ist zum Auslösen eines Funktionstests infolge einer detektierten charakteristischen Spannungsabfolge bzw. Stromabfolge.

17. Testanordnung nach einem der Ansprüche 1 bis 16,
**dadurch gekennzeichnet, daß**
- der Halbleiterchip (1) einen integrierten Speicher aufweist, der Speicherzellen (MC) enthält, die einem Funktionstest unterziehbar sind, und
- der Halbleiterchip (1) eine Selbsttesteinheit (2) zur Erzeugung von Testinformation und zur Durchführung eines Funktionstests der Speicherzellen (MC) aufweist.

18. Testanordnung nach Anspruch 17,
**dadurch gekennzeichnet, daß**
- der integrierte Speicher normale Speicherzellen (MC) und redundante Speicherzellen (RMC) zum Ersetzen von normalen Speicherzellen (MC) aufweist,
- die Selbsttesteinheit (2) zum Überprüfen der Funktionsfähigkeit der normalen Speicherzellen (MC), zur Analyse, welche der normalen Speicherzellen (MC) durch welche der redundanten Speicherzellen (RMC) zu ersetzen sind, und zur Aktivierung der redundanten Speicherzellen (RMC) entsprechend dem Analyseergebnis ausgebildet ist.

19. Testanordnung nach Anspruch 18,
**dadurch gekennzeichnet, daß**
der integrierte Speicher elektrisch programmierbare Speichereinheiten (9) aufweist zur Aktivierung der redundanten Speicherzellen (RMC), in denen ein durch die Selbsttesteinheit (2) ermitteltes Reparaturergebnis programmierbar ist.

## Claims

1. Test arrangement for the functional testing of a semiconductor chip,
- having a semiconductor chip (1), which can be subjected to a functional test for the purpose of checking the functionality of the semiconductor chip (1) arranged on a support material (10), and which has a self-test unit (2) for generating test information and for carrying out the functional test,
- having an energy source (3) for providing an electrical energy supply from energy that is fed in contactlessly,
- in which the energy source (3) is arranged on the support material (10) and is connected to the semiconductor chip (1) for the purpose of providing an energy supply for the semiconductor chip (1).

2. Test arrangement according to Claim 1,
**characterized in that**
the energy source (3) has at least one solar cell (30) for generating an operating current (IB) on the semiconductor chip (1) by means of optical radiation (31) that is fed in contactlessly.

3. Test arrangement according to Claim 2,
**characterized in that**
- the support material is a semiconductor wafer (10), on which a plurality of semiconductor chips (1) are applied,
- the semiconductor wafer (10) has a scribe line (11), which separates the semiconductor chips (1) from one another, and
- the solar cell (30) is arranged in the scribe line (11).

4. Test arrangement according to Claim 2,
**characterized in that**
the solar cell (30) is arranged on the semiconductor chip (1).

5. Test arrangement according to Claim 2,
**characterized in that**
- the support material is a semiconductor wafer (10), on which the semiconductor chip (1) is applied, and
- the solar cell (30) is arranged areally on a surface of the semiconductor wafer (10).

6. Test arrangement according to Claim 2 or 5,
**characterized in that**
- the solar cell (30) is arranged on that surface of the support material (10) which is remote from the semiconductor chip (1),
- arranged between the solar cell (30) and the semiconductor chip (1) there is an electrically conductive plated-through hole (13) in the support material (10),
- at the boundary between the plated-through hole (13) and the support material (10), a pn junction (14) is arranged along the plated-through hole (13) for the purpose of preventing a current flow between the plated-through hole (13) and the support material (10).

7. Test arrangement according to one of Claims 4 to 6,
**characterized in that**
a radiation-absorbing layer (12) is applied between the solar cell (30) and the semiconductor chip (1).

8. Test arrangement according to one of Claims 1 to 7,
**characterized in that**
the semiconductor chip (1) has a functional unit (4) for the contactless transmission of data (DA) containing information about the performance of the test and/or a test result.

9. Test arrangement according to Claim 8,
**characterized in that**
the functional unit (4) is designed to generate optical radiation pulses (41) in accordance with the data (DA) to be transmitted, which can be received by a receiver (5) outside the semiconductor chip (1).

10. Test arrangement according to Claim 8,
**characterized in that**
the functional unit (4) has an output terminal (A), via which the data (DA) to be transmitted can be transmitted by capacitive coupling to a receiver (5) outside the semiconductor chip (1).

11. Test arrangement according to Claim 8,
**characterized in that**
- a material (42) is connected to a terminal (A) of the functional unit (4), at which a potential (UA), which can be controlled by the functional unit (4), is present in accordance with the data (DA) to be transmitted,
- the material (42) effects an optical refraction (α) of optical radiation (43), which refraction can be controlled by the potential (UA),
- the material (42) can be irradiated with optical radiation (43) and optical radiation (44) refracted by the material (42) can be received by a receiver (5) outside the semiconductor chip (1).

12. Test arrangement according to one of Claims 8 to 11,
**characterized in that**
the semiconductor chip (1) has a voltage detector (6) or a current detector (6), which is connected to the energy source (3) and to the functional unit (4) for the purpose of initiating a data transmission by the functional unit (4) on account of a detected characteristic voltage sequence or current sequence.

13. Test arrangement according to one of Claims 1 to 12,
**characterized in that**
- the semiconductor chip (1) has a nonvolatile memory unit (7) for storing data (DA) which contain information about the performance of the test and/or a test result, and
- the nonvolatile memory unit (7) is connected to a terminal (EX) of the semiconductor chip (1), via which the data (DA) of the memory unit (7) can be tapped off to a point outside the semiconductor chip (1).

14. Test arrangement according to one of Claims 1 to 13,
**characterized in that**
- the test arrangement has a plurality of semiconductor chips (1) to be tested, and
- one of the semiconductor chips (1) to be tested is decoupled from the respective other semiconductor chips (1) with regard to the energy supply during a functional test.

15. Test arrangement according to one of Claims 1 to 13,
**characterized in that**
- the test arrangement has a plurality of semiconductor chips (1) to be tested,
- the test arrangement has a common energy source (3) for a plurality of the semiconductor chips (1) to be tested,
- the semiconductor chips (1) to be tested each have a current limiter circuit (32) for electrically isolating a respective semiconductor chip (1) from the energy source (3) in the event of a limit value of an operating current (IB) being exceeded.

16. Test arrangement according to one of Claims 1 to 15,
**characterized in that**
the semiconductor chip (1) has a voltage detector (6) or a current detector (6), which is connected to the energy source (3) and to the self-test unit (2) for the purpose of initiating a functional test on account of a detected characteristic voltage sequence or current sequence.

17. Test arrangement according to one of Claims 1 to 16,
**characterized in that**
- the semiconductor chip (1) has an integrated memory containing memory cells (MC) which can be subjected to a functional test, and
- the semiconductor chip (1) has a self-test unit (2) for generating test information and for carrying out a functional test of the memory cells (MC).

18. Test arrangement according to Claim 17,
**characterized in that**
- the integrated memory has normal memory cells (MC) and redundant memory cells (RMC) for replacing normal memory cells (MC),
- the self-test unit (2) is designed for checking the functionality of the normal memory cells (MC), for analysing which of the normal memory cells (MC) are to be replaced by which of the redundant memory cells (RMC), and for activating the redundant memory cells (RMC) in accordance with the result of the analysis.

19. Test arrangement according to Claim 18,
**characterized in that**
the integrated memory has electrically programmable memory units (9) for activating the redundant memory cells (RMC), in which a repair result determined by the self-test unit (2) can be programmed.

## Revendications

1. Dispositif de test pour le contrôle du fonctionnement d'une puce à semi-conducteur
- comprenant une puce (1) à semi-conducteur, qui peut être soumise à un test de fonctionnement pour contrôler l'aptitude à fonctionner de la puce (1) à semi-conducteur qui est disposée sur un matériau (10) support et qui a une unité (2) d'autotest pour la production d'informations de test et pour la réalisation du test de fonctionnement ;
- comprenant une source (3) d'énergie pour mettre à disposition une alimentation en énergie électrique constituée d'énergie apportée sans contact ;
- dans lequel la source (3) d'énergie est disposée sur le matériau (10) support et est reliée à la puce (1) à semi-conducteur pour la mise à disposition d'une alimentation en énergie de la puce (1) à semi-conducteur.

2. Dispositif de test suivant la revendication 1,
**caractérisé en ce que** la source (3) d'énergie a au moins une pile (30) solaire de production d'un courant (IB) de fonctionnement sur la puce (1 ) à semi-conducteur par du rayonnement (31) optique apporté sans contact.

3. Dispositif de test suivant la revendication 2,
**caractérisé en ce que**
- le matériau support est une tranche (10) semi-conductrice sur laquelle sont déposées plusieurs puces (1) à semi-conducteur ;
- la tranche (10) semi-conductrice a un quadrillage (11) de rainures qui sépare les puces (1) à semi-conducteur les unes des autres; et
- la pile (30) solaire est disposée dans le quadrillage (11) de rainures.

4. Dispositif de test suivant la revendication 2,
**caractérisé en ce que** la pile (30) solaire est disposée sur la puce (1 ) à semi-conducteur.

5. Dispositif de test suivant la revendication 2,
**caractérisé en ce que**
- le matériau support est une tranche (10) semi-conductrice sur laquelle est déposée la puce (1) à semi-conducteur ; et
- la pile (30) solaire est disposée à plat sur une surface de la tranche (10) semi-conductrice.

6. Dispositif de test suivant la revendication 2 ou 5,
**caractérisé en ce que**
- la pile (30) solaire est disposée sur la surface du matériau (10) support, qui est éloignée de la puce (1) à semi-conducteur ;
- il est disposé entre la pile (30) solaire et la puce (1) à semi-conducteur dans le matériau (10) support un contact (13) traversant conducteur de l'électricité ;
- à la limite entre le contact (13) traversant et le matériau (10) support, est disposée le long du contact (13) traversant une jonction (14) pn pour faire obstacle à un flux de courant entre le contact (13) traversant et le matériau (10) support.

7. Dispositif de test suivant l'une des revendications 4 à 6,
**caractérisé en ce qu'**il est déposé entre la pile (30) solaire et la puce (1) à semi-conducteur une couche (12) absorbant du rayonnement.

8. Dispositif de test suivant l'une des revendications 1 à 7,
**caractérisé en ce que** la puce (1) à semi-conducteur a une unité (4) fonctionnelle pour la transmission sans contact de données (DA) qui contiennent des informations sur la réalisation du test et/ou un résultat de test.

9. Dispositif de test suivant la revendication 8,
**caractérisé en ce que** l'unité (4) fonctionnelle est constituée pour la production d'impulsions (41) de rayonnement optique correspondant aux données (DA) à transmettre, qui peuvent être reçues par un récepteur (5) à l'extérieur de la puce (1) à semi-conducteur.

10. Dispositif de test suivant la revendication 8,
**caractérisé en ce que** l'unité (4) fonctionnelle a une borne (A) de sortie par laquelle les données (DA) à transmettre peuvent être transmises par couplage capacitif à un récepteur (5) à l'extérieur de la puce (1) à semi-conducteur.

11. Dispositif de test suivant la revendication 8,
**caractérisé en ce que**
- un matériau (42) est relié à une borne (A) de l'unité (4) fonctionnelle, borne à laquelle s'applique en fonction des données (DA) à transmettre un potentiel (UA) pouvant être commandé par l'unité (4) fonctionnelle ;
- le matériau (42) provoque une réfraction (α) optique du rayonnement (43) optique, qui peut être réglée par le potentiel (UA) ;
- le matériau (42) peut être exposé à du rayonnement (43) optique et du rayonnement (44) optique réfracté par le matériau (42) peut être reçu par un récepteur (5) à l'extérieur de la puce (1) à semi-conducteur.

12. Dispositif de test suivant l'une des revendications 8 à 11,
**caractérisé en ce que** la puce (1 ) à semi-conducteur a un détecteur (6) de tension ou un détecteur (6) de courant qui est relié à la source (3) d'énergie et à l'unité (4) fonctionnelle pour déclencher une transmission de données par l'unité (4) fonctionnelle à la suite d'une détection d'une succession caractéristique de tensions ou de courants.

13. Dispositif de test suivant l'une des revendications 1 à 12,
**caractérisé en ce que**
- la puce (1) à semi-conducteur a une unité (7) de mémoire non volatile de mémorisation de données (DA) qui contiennent des informations sur la réalisation du test et/ou sur un résultat du test ; et
- l'unité (7) de mémoire non volatile est reliée à une borne (EX) de la puce (1) à semi-conducteur par laquelle les données (DA) de l'unité (7) de mémoire peuvent être prélevées vers l'extérieur de la puce (1) à semi-conducteur.

14. Dispositif de test suivant l'une des revendications 1 à 13,
**caractérisé en ce que**
- le dispositif de test comporte plusieurs puces (1) à semi-conducteur à tester ; et
- l'une des puces (1) à semi-conducteur à tester est pendant un test de fonctionnement découplée en ce qui concerne l'alimentation en énergie des autres puces (1) à semi-conducteur.

15. Dispositif de test suivant l'une des revendications 1 à 13,
**caractérisé en ce que**
- le dispositif de test comporte plusieurs puces (1) à semi-conducteur à tester ;
- le dispositif de test a une source (3) d'énergie commune pour plusieurs des puces (1 ) à semi-conducteur à tester ;
- les puces (1) à semi-conducteur à tester ont, respectivement, un circuit (32) limiteur de courant pour la séparation électrique d'une puce (1) à semi-conducteur respective de la source (3) d'énergie dans le cas où une valeur limite d'un courant (IB) de fonctionnement est dépassée.

16. Dispositif de test suivant l'une des revendications 1 à 15,
**caractérisé en ce que** la puce (1) à semi-conducteur a un détecteur (6) de tension ou un détecteur (6) de courant qui est relié à la source (3) d'énergie et à l'unité (2) d'autotest pour déclencher un test de fonctionnement à la suite de la détection d'une succession caractéristique de tensions ou de courants.

17. Dispositif de test suivant l'une des revendications 1 à 16,
**caractérisé en ce que**
- la puce (1) à semi-conducteur à une mémoire intégrée qui comporte des cellules (MC) de mémoire qui peuvent être soumises à un test de fonctionnement ; et
- la puce (1) à semi-conducteur a une unité (2) d'autotest pour produire des informations de test et pour réaliser un test de fonctionnement des cellules (MC) de mémoire.

18. Dispositif de test suivant la revendication 17,
**caractérisé en ce que**
- la mémoire intégrée a des cellules (MC) normales de mémoire et des cellules (RMC) redondantes de mémoire destinées à remplacer des cellules (MC) normales de mémoire ;
- l'unité (2) d'autotest est constituée pour contrôler l'aptitude à fonctionner des cellules (MC) normales de mémoire, pour déterminer par analyse celles des cellules (MC) normales de mémoire qui doivent être remplacées par des cellules (RMC) redondantes de mémoire et pour activer les cellules (RMC) redondantes de mémoire en fonction du résultat de l'analyse.

19. Dispositif de test suivant la revendication 18,
**caractérisé en ce que** la mémoire intégrée a des unités (9) de mémoire programmables électriquement pour l'activation des cellules (RMC) redondantes de mémoire dans lesquelles un résultat de réparation déterminé par l'unité (2) d'autotest peut être programmé.
